# EUROPEAN PATENT APPLICATION

(11) **EP 4 557 049 A1**
(43) Date of publication of application: **21.05.2025**
(21) Application number: 23887419.2
(22) Date of filing: 25.05.2023
(51) Int. Cl.: G06F 1/20, G06F 1/18

(54) **RADIATOR**

(30) Priority: 08.11.2022 CN 202211391793
(71) Applicant: Guangdong Envicool Technology Co., Ltd., Sanjiao Town, Zhongshan Guangdong 528400 (CN)
(72) Inventor: TU, Yijian, Zhongshan, Guangdong 528400 (CN)
(74) Representative: Potter Clarkson
(86) International application number: PCT/CN2023/096202
(87) International publication number: WO 2024/098720

(57) **Abstract**

The embodiment of the present application discloses a radiator. The radiator comprises: a substrate cavity group and a cavity fin array; each cavity fin in the cavity fin array is communicated with a refrigerant air inlet channel of the substrate cavity group; and an inner wall of each cavity fin is provided with a flow guide wall having a preset incline angle structure. Hence, after a liquid working medium absorbs the heat generated by a heat source and is vaporized, the vaporized liquid working medium can pass through the refrigerant air inlet channel into an inner cavity of a cavity fin so as to perform heat exchange, and the use of a plurality of cavity fins can increase the area of heat exchange, thereby achieving efficient heat dissipation for a heat source. Moreover, the preset incline angle structure provided on an inner wall of the cavity fins helps liquefied liquid in the inner cavity of the cavity fins to flow, under the effects of gravity and with little to no impedance, back along an inclined edge of the preset incline angle structure into the substrate cavity group, thereby achieving working medium circulation within the substrate cavity group, improving working medium gas-liquid conversion efficiency, and further improving the heat exchange effect of the radiator.

## Description

The present application claims priority to Chinese Patent Application No. 202211391793.5, titled "RADIATOR", filed on November 8, 2022 with the China National Intellectual Property Administration, which is incorporated herein by reference in its entirety.

### FIELD

The present application relates to the technical field of heat dissipation devices, and in particular to a radiator.

### BACKGROUND

With the development of the times, the integration degree of electronic equipment such as a desktop computer tower is becoming higher and higher, and the computing speed is rapidly accelerated, which makes the power consumption and heat flux of the electronic equipment continuously increased, and the heat generation continuously increased.

There are at least the following problems in the conventional technology.

The conventional radiator fin has a high resistance to the liquid after being heated and liquefied, hence the heat dissipation effect of the radiator on the electronic equipment is limited, for example, the conventional radiator can only solve the heat dissipation problem of some low-end electronic equipment with low power consumption and small heat flux. Once the electronic equipment is upgraded and the heat generation is increased, it is difficult for the radiator to meet the heat dissipation requirement of the upgraded equipment.

### SUMMARY

A radiator is provided according to the embodiments of the present application, to solve the technical problem of poor heat dissipation effect of the conventional radiator.

A radiator is provided according to an embodiment of the present application. The radiator includes a baseplate-cavity assembly and a hollow fin array;
each of hollow fins in the hollow fin array is in communication with a refrigerant gas inlet channel of the baseplate-cavity assembly, to allow a liquid working medium filled in the baseplate-cavity assembly, after vaporization via heat absorption, to enter an inner cavity of the hollow fin through the refrigerant gas inlet channel for heat dissipation, and the heat absorbed by the liquid working medium is from a heat source to be cooled; and
an inner wall of each of the hollow fins is provided with a flow-guide wall having a preset inclined angle structure, the preset inclined angle structure has an inclined edge which is inclined relative to a horizontal plane, and the inclined edge is configured to guide the liquid in the inner cavity of the hollow fin back to the baseplate-cavity assembly.

In an embodiment, the hollow fins are vertically inserted into the refrigerant gas inlet channel; and/or,
the preset inclined angle structure includes an inclined square structure or an inclined semicircular structure with a preset inclined angle relative to the refrigerant gas inlet channel.

In an embodiment, the radiator further includes spoiler fins alternatively arranged with the hollow fins;
a through hole is provided in a plate wall, provided the refrigerant gas inlet channel, of each of the spoiler fins.

In an embodiment, the spoiler fin is integrally formed by stamping.

In an embodiment, a connection layer is provided on a vertical side wall, with respect to the baseplate-cavity assembly, of each of the hollow fin and the spoiler fin for mutual connection

In an embodiment, the connection layer is an aluminum material layer serving as a solder. Specifically, the connection layer may be a 4343 aluminum material layer or a 4045 aluminum material layer.

In an embodiment, the spoiler fin includes wave-shaped toothed plates, each of the wave-shaped toothed plates is of a rectangular wave shape or a sinusoidal wave shape; and
a tooth pitch between adjacent two of the wave-shaped toothed plates is 2.2±0.2mm, and a thickness of a plate wall of each of the wave-shaped toothed plates is 0.2±0. 1mm.

In an embodiment, the baseplate-cavity assembly includes a cavity cover plate, a baseplate-cavity portion, and a liquid-sucking core structure; where
the cavity cover plate is mounted at a top of the baseplate-cavity portion, the number of the refrigerant gas inlet channel is greater than or equal to the number of the hollow fin, and the refrigerant gas inlet channels are provided in the cavity cover plate; and
the liquid-sucking core structure is mounted inside the baseplate-cavity portion, and the liquid-sucking core structure is configured to allow the liquid working medium filled in the baseplate-cavity portion to absorb heat and be vaporized into a gaseous working medium going to the hollow fins.

In an embodiment, the liquid-sucking core structure is a cylindrical structure with a diameter φ of 1mm and a height of 3mm.

In an embodiment, the radiator further includes a fin guard plate; where
the fin guard plate is vertically mounted on a side end of the baseplate-cavity assembly to form an enclosure for the hollow fin array in a peripheral direction.

It can be seen from the above technical solutions that the embodiments of the present application have at least the following advantages.

After being vaporized by absorbing the heat generated by the heat source, the liquid working medium enters the inner cavity of the hollow fin through the refrigerant gas inlet channel for heat exchange, and the use of multiple hollow fins can increase the heat exchange area, to realize efficient heat dissipation of the heat source. In addition, the preset inclined angle structure provided on the inner wall of the hollow fin helps the liquid formed by liquidation in the inner cavity of the hollow fin to flow back, under the action of gravity, into the baseplate-cavity assembly along the inclined edge of the preset inclined angle structure with weak resistance or even without resistance, thereby realizing the circulation of the working medium in the baseplate-cavity assembly, improving the gas-liquid conversion efficiency of the working medium, and further improving the heat exchange effect of the radiator.

### BRIEF DESCRIPTION OF THE DRAWINGS

In order to more clearly illustrate the technical solutions in the embodiments of the present application, drawings required in the description of the embodiments are briefly introduced below. Apparently, the drawings in the following description are only some embodiments described in the present application. For those skilled in the art, other drawings can be obtained based on these drawings.
FIG. 1a is a schematic view showing a conventional radiator being assembled in a computer tower;
FIG. 1b is a schematic view showing the structure of a conventional heat dissipation module in the structure of FIG. 1a;
FIG. 2 is a schematic view showing flowing of a working medium in the conventional heat dissipation module;
FIG. 3 is a schematic view showing the structure of a radiator according to an embodiment of the present application;
FIG. 4a is a schematic view showing a side of a hollow fin according to the embodiment of the present application;
FIG. 4b is a schematic view showing another side of the hollow fin according to the embodiment of the present application;
FIG. 4c is a schematic view showing yet another side of the hollow fin according to the embodiment of the present application;
FIG. 5 is a schematic view showing the structure of a radiator according to another embodiment of the present application;
FIG. 6a is a schematic view showing a side of a spoiler fin according to the another embodiment of the present application;
FIG. 6b is a schematic view showing another side of the spoiler fin according to the another embodiment of the present application and a partially enlarged view thereof;
FIG. 6c is a schematic view showing yet another side of the spoiler fin according to the another embodiment of the present application and a partially enlarged view thereof;
FIG. 7a is a schematic view showing an assembly of the radiator according to the embodiment of the present application being assembled in a computer tower;
FIG. 7b is a schematic view showing a side in FIG. 7a;
FIG. 8a is a schematic view showing the structure of a baseplate-cavity assembly according to an embodiment of the present application;
FIG. 8b is a schematic view showing an inner structure in FIG. 8a;
FIG. 8c is a schematic view showing a structure in FIG. 8b;
FIG. 9 is a schematic view showing heat dissipation of the radiator according to the embodiment of the present application in the computer tower; and
FIG. 10 shows comparison between simulation effects of the conventional radiator and the radiator according to the embodiment of the present application.

Reference numerals:

| | | | |
|---|---|---|---|
| 1 | casing, | | power source, |
| 3 | inductor, | 2 4 | resistor, |
| 5 | cooling fan, | 6 | capacitor, |
| 7 | integrated circuit (IC) chip, | 8 | PCB (printed circuit board), |
| 9 | extruded aluminum profile, | 10 | heat pipe, |
| 11 | copper plate, | 12 | heat pipe groove, |
| 13 | CPU, | 14 | capillary structure, |
| 15 | evaporation section, | 16/27 | liquid working medium, |
| 17 | condensation section, | 18 | radiator, |
| 19 | power consumption area of PCB, | 20 | spoiler fin, |
| 201 | through hole, | 21 | hollow fin, |
| 210 | preset inclined angle structure, | 22 | baseplate-cavity assembly, |
| 23 | liquid-sucking core structure, | 24 | cavity cover plate, |
| 25 | baseplate-cavity portion, | 26 | refrigerant gas inlet channel, |
| 28 | gaseous working medium, | 29 | fin guard plate. |

### DETAILED DESCRIPTION OF THE EMBODIMENTS

For those skilled in the art to better understand the solutions of the present application, the technical solutions in the embodiments of the present application are clearly and completely described below in conjunction with the drawings. Obviously, the described embodiments are only a part of the embodiments of the present application, rather than all embodiments. All other embodiments obtained by those skilled in the art based on the embodiments in the present application without creative efforts shall fall within the protection scope of the present application.

In the description of the embodiments of the present application, it should be noted that, orientations or positional relationships indicated by terms such as "center", "up", "down", "left", "right", "vertical", "horizontal", "inside" and "outside" are based on the orientations or position relationships shown in the drawings, and are only for the convenience of describing the embodiments of the present application and simplifying the description, rather than indicating or implying that devices or elements referred to must have specific orientations, or must be constructed and operated in specific orientations, and thus should not be understood as limitations to the embodiments of the present application. In addition, terms "first", "second" and "third" are only used for description, and should not be understood as indicating or implying relative importance.

In the description of the embodiments of the present application, it should be noted that, unless otherwise clearly specified and limited, terms "mount", "connect" and "joint" should be understood in a broad sense, for example, it may refer to a fixed connection, a detachable connection, or an integrated connection; may refer to a mechanical connection or an electric connection; may be a direct connection, or an indirect connection through an intermediate medium, or may refer to internal communication between two elements. For those skilled in the art, the specific meanings of the terms in the embodiments of the present application can be understood based on specific situations.

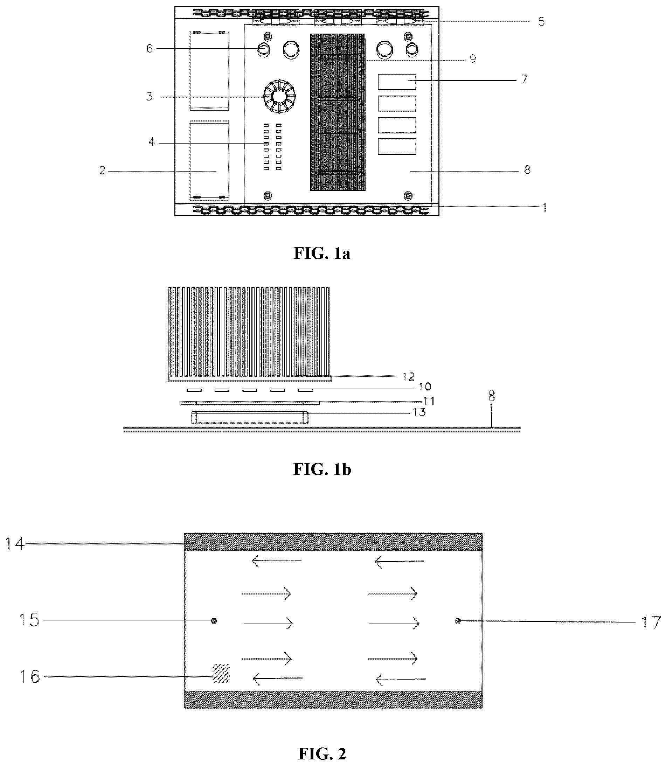

As shown in FIGS. 1a and 1b, a radiator currently used in a desktop computer tower generally employs a conventional heat dissipation module, for example, a combination of a heat pipe, a copper plate and an extruded aluminum profile or a combination of a heat pipe, a copper plate and a heat exchange plate, and surrounding components of the heat dissipation module include a casing 1, a power source 2, an inductor 3, a resistor 4, a cooling fan 5, a capacitor 6, and an integrated circuit (IC) chip 7. There are many power consumption electronic components inside the computer tower, and a main heat-generating element is a central processing unit (CPU) 13. Specifically, the conventional heat dissipation module mainly includes three components, namely, an extruded aluminum profile 9, a heat pipe 10, and a copper plate 11. During the manufacturing process, after the three components are assembled, a heat dissipation product can be formed by welding in a soldering furnace with the help of solder paste coated on welding surfaces of the three components, where the heat pipe 10 is embedded in a heat pipe groove 12. During the use, the entire radiator is fixedly locked inside the computer tower, and is generally fixedly locked right above the CPU 13. After the computer system starts to work, heat generated in a power consumption area of the CPU 13 is sequentially transferred to the heat pipe 10, the copper plate 11, and the extruded aluminum profile 9 through a thermal conductive medium (such as a working medium), and the cooling fan 5 drives the heat in the heat pipe groove 12 out of the computer tower system. Moreover, part of heat of power consumption elements on a printed circuit board 8 is also be taken outside the computer tower system, e.g. outside the casing, by the wind of the cooling fan 5.

It can be seen that conventionally, the core component of the entire heat dissipation module is the heat pipe 10. As shown in FIG. 2, after the heat pipe is started, the heated liquid working medium 16 flows from an evaporation section 15 to a condensation section 17 (arrows pointing to the right), the working medium flows back under a capillary force of a capillary structure (e.g. copper powder/copper mesh/groove) 14 after being cooled, that is, the working medium flows from the condensation section 17 to the evaporation section 15, and the process is repeated so as to achieve heat exchange balance. However, the conventional water-cooling heat dissipation module generally uses pure water as the working medium 16, after the pure water is filled into the heat pipe to work, the phase transformation process of the pure water is slight, and the heat exchange efficiency of the working medium is low, so when the heat pipe is too long or the power consumption of the CPU is too high, the conventional radiator product is prone to be dried out or heat dissipation performance may be attenuated, which cannot meet the heat dissipation requirements of current or upgraded electronic equipment. In addition, a power pump is required to be added for the conventional water-cooling heat dissipation module, to drive the circulation of the working medium in the heat dissipation module, in addition, a sensor is required to be mounted to detect leakage of water in the module product, hence, there are too many auxiliary parts, and the assembly is difficult.

The structure and the usage of the conventional radiator are described above. A radiator according to the present application is described in detail hereinafter. As an example, in the actual assembly process, the radiator is fixedly locked above a power consumption area of a CPU and faces the heat source surface of PCB of the computer tower for use.

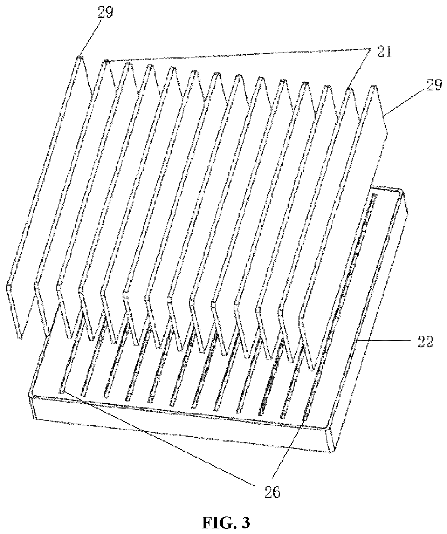

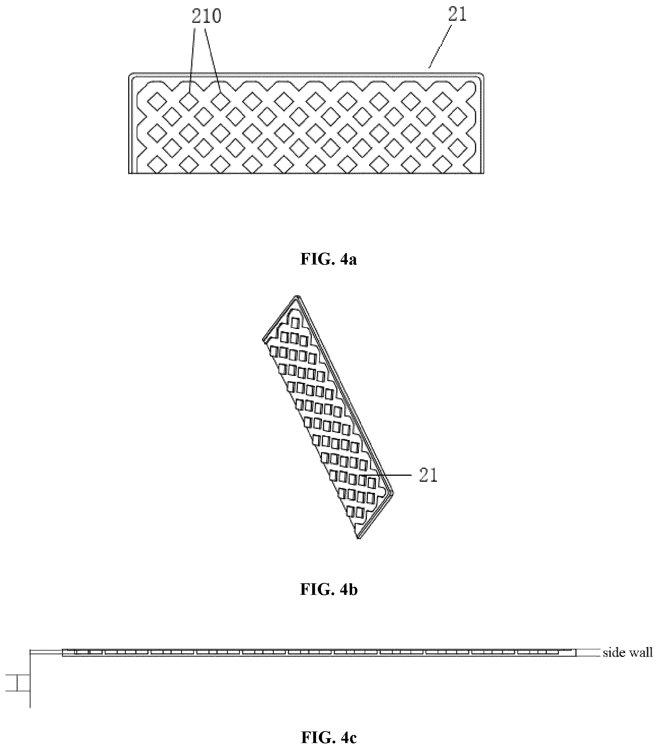

Referring to FIGS. 3 to 4b, a radiator is provided according to an embodiment of the present application. The radiator includes:
a baseplate-cavity assembly 22 and a hollow fin array, each of hollow fins 21 in the hollow fin array is in communication with a refrigerant gas inlet channel 26 of the baseplate-cavity assembly, to allow a liquid working medium filled in the baseplate-cavity assembly, after vaporization via heat absorption, to enter an inner cavity of the hollow fin through the refrigerant gas inlet channel 26 for heat dissipation, and the heat absorbed by the liquid working medium comes from a heat source (for example, a CPU) to be cooled; an inner wall of the hollow fin 21 is provided with a flow-guide wall having a preset inclined angle structure 210, the preset inclined angle structure 210 has an inclined edge which is inclined relative to a horizontal plane, and the inclined edge is configured to guide the liquid in the inner cavity of the hollow fin back to the baseplate-cavity assembly.

It can be seen that the heat generated by the heat source can be absorbed by the liquid working medium for vaporization, and the working medium is introduced to the inner cavity of the hollow fin through the refrigerant gas inlet channel for heat exchange. The use of multiple hollow fins can increase the heat exchange area to realize efficient heat dissipation of the heat source. In addition, the preset inclined angle structure of the inner wall of the hollow fin reduces the resistance applied to the liquid formed by liquidation in the inner cavity of the hollow fin, so that the liquid flows back to the baseplate-cavity assembly along the inclined edge of the preset inclined angle structure more smoothly, thereby realizing the circulation of the working medium in the baseplate-cavity assembly, improving the gas-liquid conversion efficiency of the working medium, and further improving the heat exchange effect of the radiator. Therefore, it can be understood that the use of the preset inclined angle structure can effectively improve the resource utilization rate of the working medium and maintain the heat exchange balance of the radiator.

On the basis of the above embodiment describing the radiator according to the present application, some specific embodiments are provided below. In practical applications, the implementation content of these embodiments can be combined and implemented as required according to the corresponding functional principles and the application logic.

In an embodiment, the hollow fin 21 is vertically inserted into the refrigerant gas inlet channel 26, and/or, the preset inclined angle structure 210 inside the hollow fin 21 includes an inclined square structure or an inclined semicircular structure having a preset inclined angle relative to the refrigerant gas inlet channel. Of course, the hollow fin may be indirectly communicated with the refrigerant gas inlet channel through a fitting (such as a screw or an adhesive). The preset inclined angle structure may be set in other shapes other than the inclined square shape or the inclined semicircular shape, as long as the design of the shape helps to reduce liquid resistance and has a flow-guide effect on liquid. In practical applications, steam (including the gaseous working medium obtained by vaporization of the liquid working medium) flows upwards in a vertical direction, and when the steam is liquefied into liquid when being cooled, the liquid flows downwards, under the gravity of itself, into the baseplate-cavity assembly along the inclined edge of the preset inclined angle structure, thereby effectively reducing wetting damage to the radiator assembly and improving the recycling of the working medium. In addition, the backflow effect can be used to preliminarily determine whether the heat dissipation capacity of the radiator is ineffective. In an embodiment, as shown in FIGS. 4a to 4c, the preset inclined angle structure 210 may be a structure of an inclined square having an area of 5×5mm and an inclined angle of 45° relative to the refrigerant gas inlet channel, and a width H of a refrigerant gas inlet corresponding to the hollow fin of this structure may be 1.5mm.

In addition, the radiator according to the present application may further include a fin guard plate 29 as shown in FIG. 3, and the fin guard plate 29 is vertically mounted at a side end of the baseplate-cavity assembly to form an enclosure for the hollow fin array in a peripheral direction, to protect hollow fin from being damaged by external force impact. Specifically, two fin guard plates are vertically welded at both ends of the baseplate-cavity assembly, that is, the two fin guard plates are arranged at a head end and a tail end of the hollow fin array. The fin guard plate may be a solid cover plate formed by stamping, and compared with the aluminum extrusion process, the cover plate formed by stamping is simple in processing and stable in structure.

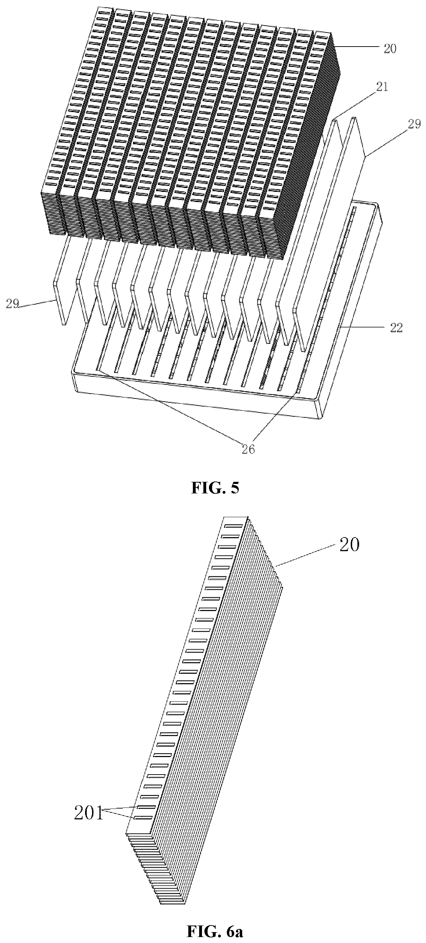

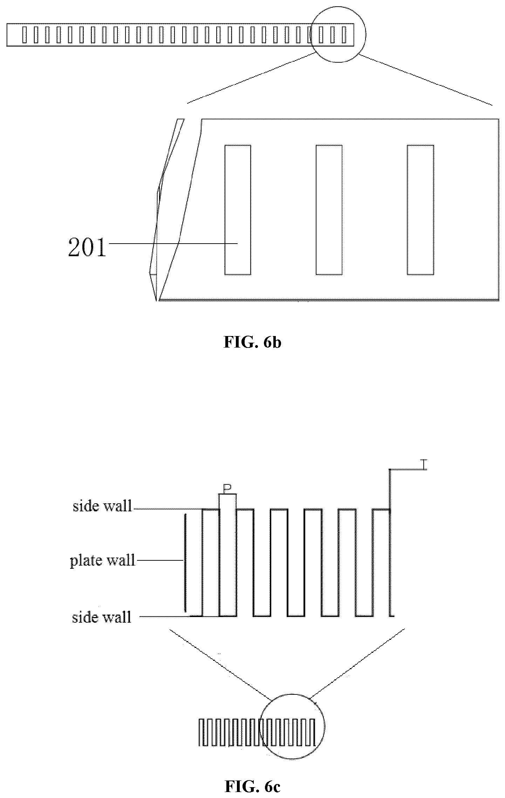

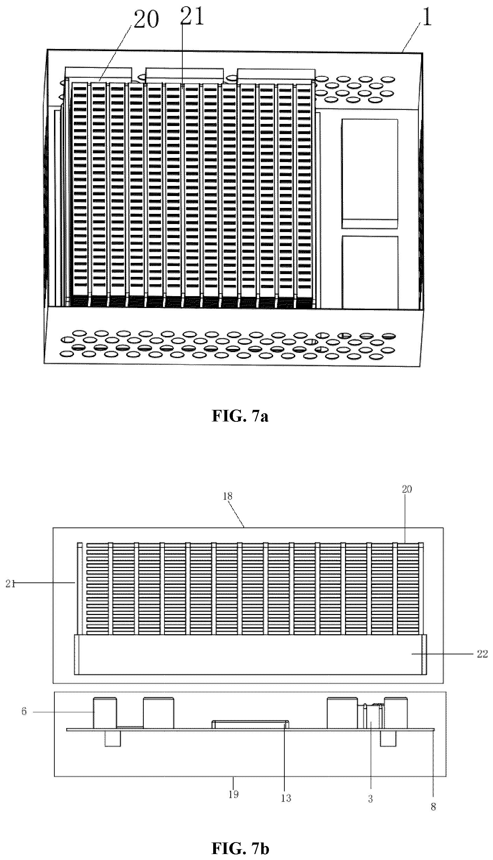

As shown in FIGS. 5 to 6c, in some embodiments, the radiator according to the present application may further include spoiler fins 20 (which may be referred to as spoiler fins or spoiler structures) alternatively arranged with the hollow fins, and a through hole 201 (such as a square through hole) is formed in a plate wall, facing the refrigerant gas inlet channel, of each of the spoiler fins 20. In an embodiment, the spoiler fin includes wave-shaped toothed plates, each of the wave-shaped toothed plates is of a rectangular wave shape or a sinusoidal wave shape. A tooth pitch P (Pitch) between two adjacent wave-shaped toothed plates may specifically be 2.2±0.2mm, and a thickness T (thickness) of a plate wall of each of the wave-shaped toothed plates may be 0.2±0.1mm. Alternatively, the wave-shaped toothed plate may be a plate in other shapes other than the rectangular wave shape or the sinusoidal wave shape, as long as the design of this shape can provide up-down misalignment or undulations to maximize the heat exchange area, so as to improve the heat dissipation effect, and the tooth pitch and the thickness of the plate wall of the wave-shaped toothed plate can be set according to actual needs (such as the heat exchange efficiency). Specifically, as shown in FIGS. 5, 7a, and 7b, multiple spoiler fins 20 (or called spoiler structures) with the tooth pitch P of 2.2mm and the thickness T of the plate wall of 0.1mm are stacked to form a fin group, and fin through holes 201 are provided in the plate wall of each of the spoiler structures, and the fin through holes 201 are aligned in one-to-one correspondence between the spoiler structures, to form a through-hole air duct. When the cooling fan (may be mounted on an inner side of the casing marked with label 1 in FIG. 7a) blows from a side, the wind can flow from one spoiler structure to another spoiler structure through the through-hole air duct, thereby increasing the heat exchange area and improving the heat dissipation performance of the radiator. In addition, in order to ensure the overall hardness and the surface flatness of the spoiler fin (to prevent surface bulging during aluminum extrusion process), the spoiler fin may be formed in one piece by stamping, and the material of the spoiler fin may be a coiled material of AL3003, which is easy to braze.

In some specific embodiments, a connection layer, e.g. an aluminum material layer serving as a solder (which may specifically be a 4343 aluminum material layer or a 4045 aluminum material layer), is provided on a vertical side wall, with respect to the baseplate-cavity assembly, of each of the hollow fin and the spoiler fin for mutual connection, so that the spoiler fin according to the present application can be directly welded (e.g. by brazing) on outer side walls of two adjacent hollow fins without conventional solder paste. Alternatively, the connection layer may also be other materials other than 4343 or 4045 aluminum materials, as long as the material can replace solder paste to maintain the connection relationship between the hollow fin and the spoiler fin, and achieve the heat transfer effect. In practical applications, the connection layer may embodied as a component of the plate wall of the wave-shaped toothed plate, for example, a thickness of the connection layer accounts for half of the thickness 0.2±0.1 mm of the plate wall mentioned above,.

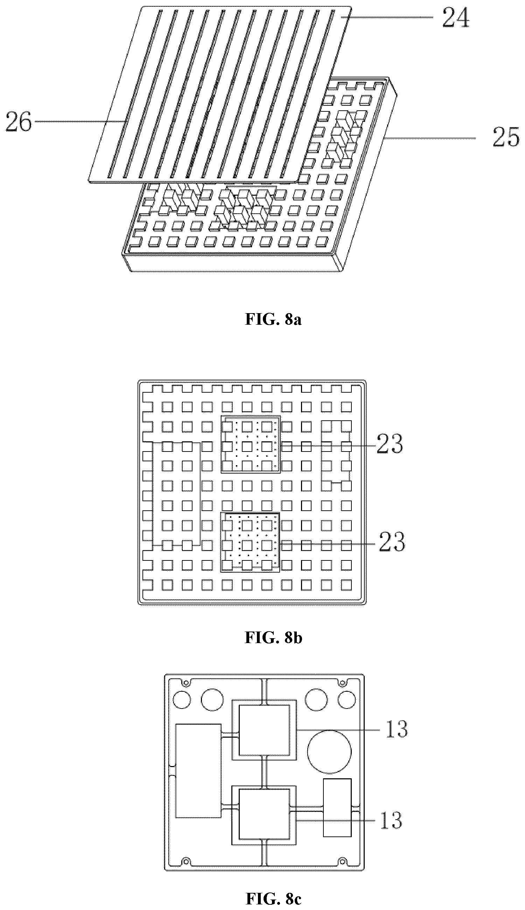

As shown in FIGS. 8a and 8b, in some specific embodiments, the baseplate-cavity assembly may specifically include a cavity cover plate 24, a baseplate-cavity portion 25, and a liquid-sucking core structure 23. The cavity cover plate is mounted at a top of the baseplate-cavity portion (for example, the cavity cover plate and the baseplate-cavity portion are combined by brazing), and multiple refrigerant gas inlet channels 26, the number of which is greater than or equal to the number of hollow fins, are formed in the cavity cover plate to ensure that the heat of the heat source has more heat dissipation paths, so as to shorten the heat dissipation time. In order to deal with and dissipate the heat generated in a power consumption heat source area and improve the heat dissipation performance, during the arrangement process, the liquid-sucking core structure 23 may be mounted inside the baseplate-cavity portion and face the heat source, and the liquid-sucking core structure 23 is configured to allow the liquid working medium filled in the baseplate-cavity portion to absorb heat and be vaporized into a gaseous working medium going to the hollow fins.

Specifically, as shown in FIGS. 8b and 8c, two CPUs 13, which are heat sources, in the middle are high power consumption areas or main heat source areas during the operation of the entire PCB. In order to ensure the normal operation of electronic equipment and the reliability of related products, the liquid-sucking core structures 23 may be provided to the radiator in the heat source areas corresponding to the two CPUs 13, so that the liquid-sucking core structures enhance the boiling of the liquid working medium, i.e. the boiling of the refrigerant, and also enhance the liquefaction and the liquid absorption capacity in the backflow process, thereby promoting the circulation of the working medium and improving the operation performance of the product.

In addition, according to practical experience, the liquid-sucking core structure 23 according to the present application may specifically be a cylindrical structure with a diameter φ of 1mm and a height of 3mm. With this thermosyphon liquid-sucking core structure with these verified parameters, not only the structure and the production process are simpler than the conventional capillary structure formed by sintering, but also a better liquid-sucking effect can be achieved by the capillary force, so as to improve the circulation of the working medium and the heat exchange capacity of the radiator.

In some specific embodiments, a two-phase transformation refrigerant such as R134a or R1233zd may be used as the liquid working medium (which may be referred to as a heat dissipation working medium or a refrigerant) in the present application to solve the problems that the equipment is burnt out due to the fact that the heat dissipation amount per unit area cannot be increased or the heat dissipation is not timely while the power consumption of the electronic equipment is increased, that is, to solve the heat dissipation problem of upgraded high-power-consumption electronic equipment.

In some specific embodiments, the height of the hollow fin may be increased according to actual needs, such as the height of the computer tower, to obtain a larger cavity volume and a greater heat exchange area. The radiator according to the present application may mainly be made of aluminum material, and assembled, positioned, and clamped on a brazing fixture, and finally formed by brazing in an aluminum brazing tunnel furnace.

In summary, as shown in FIGS. 5, 7a, and 7b, on the basis of the baseplate-cavity assembly and the hollow fin array, another fin may be added in the radiator according to the present application. After the above three parts are welded through an aluminum brazing process and assembled into to form the radiator, the radiator can be fixedly locked above the PCB power consumption area 19 (similar to a power consumption area of a conventional heat dissipation module) as a whole by a screw, so that the PCB power consumption area 19 and the radiator 18 are combined to form a working module of the computer tower, and the radiator 18 starts to work after the PCB power consumption area 19 starts to consume power. The bottom of the baseplate-cavity portion can be in contact with power consumption elements other than the CPU, so that the radiator can also perform auxiliary heat dissipation on various power consumption elements, to reduce the temperature in the computer tower. The hollow fins and the spoiler fins which are alternatively arranged with respect to each other may be regarded as a heat exchange cavity of the radiator, and the heat exchange cavity is configured to provide a greater heat exchange area for the heat generated by the heat source, so that the radiator product not only can be applied to current mid-end electronic equipment, but also can deal with the heat dissipation problems of upgraded high-end servers and upgraded desktop computer towers, which lays the foundation for the heat dissipation of future high-end electronic equipment and broadens the application field.

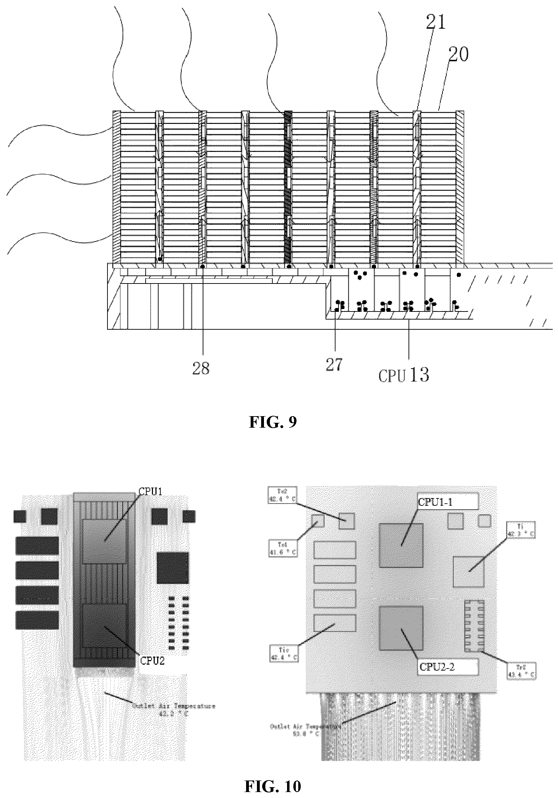

As shown in FIG. 9, a working process of the radiator as shown in FIGS. 5 and 7a includes the following steps: after being heated a heat source surface of CPU, a liquid working medium 27 absorbs heat and is vaporized into a gaseous working medium 28 inside the baseplate-cavity assembly, and the gaseous working medium 28 enters the hollow fin through the refrigerant gas inlet channel 26 and transfer heat to the another fin in a direction of a side wall of the hollow fin for heat exchange; at the same time, the heat is taken out of the radiator and the computer tower from directions such as a horizontal direction and a vertical direction under the action of the wind of the cooling fan, so as to realize continuous and efficient heat dissipation of the high-power-consumption product. In addition, the liquid working medium in in the gas-liquid mixture is guided back into the baseplate-cavity assembly through the preset inclined angle structure of the hollow fin under the action of gravity, thereby promoting the cyclic utilization of the working medium and repeated heat dissipation of the heat source.

Finite element analysis and comparison are performed below on the conventional radiator and the radiator according to the present application. The radiator according to the present application is provided with spoiler fins and the liquid-sucking core structure with the diameter φ of 1mm and the height of 3mm, and the refrigerant R134a serves as the liquid working medium. Since the main power consumption of electronic equipment (computer tower) is concentrated on the two CPUs, the simulation comparison result is only required to reflect the temperatures of the two CPUs.

Specifically, the conventional radiator faces CPU1 and CPU2, the radiator according to the present application faces CPU1-1 and CPU2-2, where a power consumption parameter of each of the four CPUs is 350W, an air volume Q of the cooling fan of each of the two radiators is 120CFM, and the ambient temperature Ta of the two radiators is 25 degrees Celsius. 3D images are imported into the finite element analysis software Flotherm, and then fillet optimization of components is performed. The simulation result of the entire computer tower system is shown in FIG. 10, where a diagram on the left is a simulation schematic diagram of the conventional radiator, and a diagram on the right is a simulation diagram of the radiator according to the present application.

When the computer tower system is balanced, the temperature of CPU1 is 50.1°C, and the temperature of CPU2 is 58.7°C; the temperature of CPU1-1 is 46.1°C, and the temperature of CPU2-2 is 46.7°C. The two sets of data show that the heat dissipation effects of the radiator according to the present application on the CPUs are better than the heat dissipation effects of the conventional radiator on the CPUs by 4 degrees Celsius and 12 degrees Celsius, respectively. It can be seen that the radiator according to the present application can achieve a better heat dissipation level than the conventional radiator, which can effectively meets the heat dissipation requirement of the high-power-consumption products. It should be noted that even if the radiator according to the present application is not provided with the spoiler fins, since the radiator has the hollow fins with a certain heat exchange area, the heat dissipation effect of the radiator is still better than the conventional radiator mentioned above.

The above embodiments are only used to illustrate the technical solutions of the present application, rather than limiting the technical solutions of the present application.

## Claims

1. A radiator, comprising a baseplate-cavity assembly and a hollow fin array, wherein
each of hollow fins in the hollow fin array is in communication with a refrigerant gas inlet channel of the baseplate-cavity assembly, to allow a liquid working medium filled in the baseplate-cavity assembly, after vaporization via heat absorption, to enter an inner cavity of the hollow fin through the refrigerant gas inlet channel for heat dissipation, and the heat absorbed by the liquid working medium is from a heat source to be cooled; and
an inner wall of each of the hollow fins is provided with a flow-guide wall having a preset inclined angle structure, the preset inclined angle structure has an inclined edge which is inclined relative to a horizontal plane, and the inclined edge is configured to guide the liquid in the inner cavity of the hollow fin back to the baseplate-cavity assembly.

2. The radiator according to claim 1, wherein
the hollow fins are vertically inserted into the refrigerant gas inlet channel; and/or,
the preset inclined angle structure includes an inclined square structure or an inclined semicircular structure with a preset inclined angle relative to the refrigerant gas inlet channel.

3. The radiator according to claim 1, further comprising spoiler fins alternatively arranged with the hollow fins; wherein
a through hole is provided in a plate wall, facing the refrigerant gas inlet channel, of each of the spoiler fins.

4. The radiator according to claim 3, wherein the spoiler fin is integrally formed by stamping.

5. The radiator according to claim 3 or 4, wherein a connection layer is provided on a vertical side wall, with respect to the baseplate-cavity assembly, of each of the hollow fin and the spoiler fin for mutual connection.

6. The radiator according to claim 5, wherein the connection layer is an aluminum material layer serving as a solder.

7. The radiator according to claim 3, wherein the spoiler fin comprises wave-shaped toothed plates, each of the wave-shaped toothed plates is of a rectangular wave shape or a sinusoidal wave shape; and
a tooth pitch between adjacent two of the wave-shaped toothed plates is 2.2±0.2mm, and a thickness of a plate wall of each of the wave-shaped toothed plates is 0.2±0. 1mm.

8. The radiator according to claim 1, wherein the baseplate-cavity assembly comprises a cavity cover plate, a baseplate-cavity portion, and a liquid-sucking core structure; wherein
the cavity cover plate is mounted at a top of the baseplate-cavity portion, the number of the refrigerant gas inlet channel is greater than or equal to the number of the hollow fin, and the refrigerant gas inlet channels are provided in the cavity cover plate; and
the liquid-sucking core structure is mounted inside the baseplate-cavity portion, and the liquid-sucking core structure is configured to allow the liquid working medium filled in the baseplate-cavity portion to absorb heat and be vaporized into a gaseous working medium going to the hollow fins.

9. The radiator according to claim 8, wherein the liquid-sucking core structure is a cylindrical structure with a diameter φ of 1mm and a height of 3mm.

10. The radiator according to claim 1, further comprising a fin guard plate; wherein
the fin guard plate is vertically mounted on a side end of the baseplate-cavity assembly to form an enclosure for the hollow fin array in a peripheral direction.
